Europäisches Patentamt

(19) European Patent Office

Office européen des brevets

(11) Publication number: **0 055 570**
**A2**

# (12) EUROPEAN PATENT APPLICATION

(21) Application number: **81305982.1**

(22) Date of filing: **21.12.81**

(51) Int. Cl.³: **H 03 K 19/017**
**H 03 K 19/003, H 03 K 19/094**
**H 03 K 19/20**

(30) Priority: **24.12.80 JP 183447/80**
**24.12.80 JP 183430/80**

(43) Date of publication of application:
**07.07.82 Bulletin 82/27**

(84) Designated Contracting States:
**DE FR GB NL**

(71) Applicant: **FUJITSU LIMITED**
**1015, Kamikodanaka Nakahara-ku**
**Kawasaki-shi Kanagawa 211(JP)**

(72) Inventor: **Nishiuchi, Koichi**
**25-29, Ohnodai 1-chome**
**Sagamihara-shi Kanagawa 229(JP)**

(74) Representative: **Sunderland, James Harry et al,**
**HASELTINE LAKE & CO Hazlitt House 28 Southampton**
**Buildings Chancery Lane**
**London WC2A 1AT(GB)**

(54) **Logic circuit.**

(57) A logic circuit has a first logic gate (G₆), having a plurality of inputs (a and b) and an output (m), and a second logic gate comprising a driving FET (Q₆) and a plurality of load FET's (T₆' and T₆). The gate of the driving FET (Q₆) is connected to the output (m) of the first logic gate and the gates of the load FET's (T₆' and T₆) are connected to respective inputs (a, b) of the first logic gate. The driving FET and the load FET's are connected in series.

A pair of FET's (T', T), one depletion-mode and one enhancement-mode, with their drains, sources and gates respectively connected in common may be used in place of a single load FET.

*Fig. 7*

*Fig. 12*

Croydon Printing Company Ltd.

- 1 -     HL24252

## LOGIC CIRCUIT

This invention relates to a logic circuit, and more particularly to an integrated logic circuit which uses a transistor as a load element.

With regard to various integrated logic circuits, including MOS integrated circuits etc., the development of integrated circuits having better performance and larger scale integration has been desired.

Among the aspects of performance of logic circuits which are to be considered are the switching rate, the rate at which a high (H) level changes to a low (L) level, or vice versa, of the logic circuit and the power consumption which is required for maintaining operation of the logic circuit. Further, there is noise immunity etc., whereby the logic circuit can operate properly without erroneous response to noise. On the other hand, from the standpoint of enhancement of integrated circuit performance, reduction of cost and improvement of functions, it is desired to increase density of integration. Various forms of logic circuit have been proposed for realising the various requirements, mentioned above, including forms of bipolar integrated circuits and MOS integrated circuits, which each have their own particular features. In particular, MOS integrated circuits have the merit of high packaging density as compared with bipolar integrated circuits etc. and have been widely adopted in large-scale integrated circuits (abbreviated to "LSI") etc.

A large number of MOS integrated circuit forms have heretofore been used, each form having its particular features and merits and demerits. In general, an inverter circuit, which is the basic gate of a logic circuit, is provided by connecting a load element to a single driving transistor. In the case of an MOS integrated circuit, an MOS transistor is ordinarily employed as the load element. Various aspects of performance and other features are provided by the different sorts of load transistors, operating mechanisms, etc., and the different forms of MOS integrated circuits are classified in accordance with those aspects and features. Three previously proposed forms of MOS integrated circuits have been extensively used:-an enhancement - enhancement type circuit (abbreviated to "E/E type circuit"), an enhancement - depletion type circuit (abbreviated to "E/D type circuit") and a complementary MOS circuit (abbreviated to "C-MOS circuit").

An E/E type circuit is a circuit which uses enhancement-mode MOS transistors for both a driving transistor and a load transistor. As illustrated in Fig. 1A of the accompanying drawings, which is a circuit diagram, the gate terminal of a load transistor 2 is usually fixed to a power source potential.

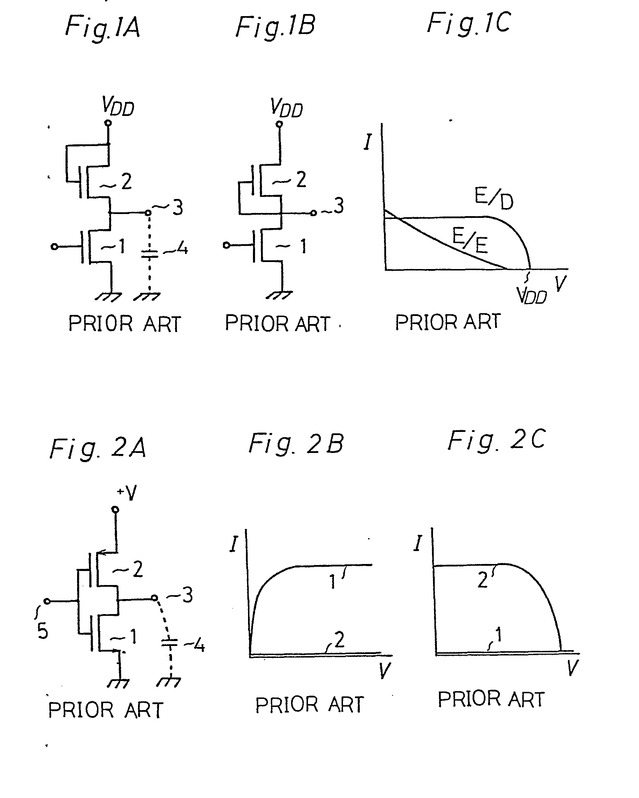

On the other hand, an E/D type circuit employs an enhancement-mode MOS transistor as a driving transistor and a depletion-mode MOS transistor as a load transistor. As illustrated in Fig. 1B of the accompanying drawings, which is a circuit diagram, the gate terminal of a load transistor 2 is connected to an output terminal 3.

The operations of the circuits of Figs. 1A and 1B will be briefly described.

When an input is of a low (L) level, so that the driving transistor 1 is in its non-conductive ("off") state, a high (H) level appears at the output terminal 3 through the pull-up load transistor 2. In contrast, when the input is of H level, the driving transistor 1 falls into its conductive ("on") state and short-circuits the output terminal 3 to the ground potential, so that the L level appears at the output. Thus, an inverting operation is executed.

The E/E type and E/D type circuits are very simple in their circuit arrangement, and they are constructed of only MOS transistors, of either n-channel or p-channel polarity, and they are suitable for IC implementation and are extensively utilised. With these circuits, however, as will be apparent from the above explanation of their operation, in order to provide an L level of a sufficiently low magnitude at the output when the driving transistor is "on", the current of the load transistor needs to be set at a low magnitude, below about 1/10 of the current of the driving transistor. On the other hand, when a transient response change is considered, with regard to the switching rate of the gate circuit, the shift of the driving transistor from "on" to "off", and the consequent shift of the output terminal from L to H, does not take place instantly, but output potential rises for the first time when a load capacitance (4 in Fig. 1A), composed of several parasitic capacitances existent at the output terminal point, is charged by the current from the load transistor. At this time, in the E/E type circuit, load current is much smaller than the "on" current of the driving transistor for the reason given above. Accordingly, the charging process takes a very long time and governs the switching speed of the gate circuit. These circumstances are apparent from the load curves of the load elements depicted on voltage-current characteristics of the driving transistors in Fig. 1C of the accompanying drawing. In particular, it is a serious demerit of the E/E type circuit that the load characteristic of the E/E type circuit is downwardly convex, so the charging current becomes lower as output potential becomes higher. The E/D type circuit offers an improvement in this respect so as to attain a high charging efficiency. Since the E/D type circuit can hold the gate-source voltage of the load transistor constant, it exhibits a load characteristic of substantially constant current as shown in Fig. 1C and can operate at higher speed.

As will be apparent from the explanation of operations given above, the load transistor is normally in the "on" state in the above E/E type and E/D type circuits. Accordingly, in a gate circuit in which the driving transistor is "on", load current normally flows from the power source potential on to the ground side, and power is normally consumed in order to maintain a logical status. Especially in recent years, high-speed operation has been required together with large-scale integration. In such circuits, operating current level needs to be made high, so that power consumption is increased. In its turn, power consumption has become even the most important factor limiting the scale of integration.

In comparison with the foregoing E/E type and E/D type circuits, C-MOS circuits have more nearly ideal features as a form of logic circuit    . Fig. 2A of the accompanying drawings is a circuit diagram of a C-MOS circuit. This circuit is so arranged that transistors of both polarities, an n-channel MOS transistor 1 and a p-channel MOS transistor 2, are symmetrically connected. An output terminal 3 is led out from the node between the drains of the two transistors, whilst an input terminal 5 is connected to the gate terminals of the two transistors.

In operation, when the input is of H level, the n-channel transistor 1 is "on", and the p-channel transistor 2 is "off", so that L level appears at the output. In contrast, when the input is of L level, the n-channel transistor 1 turns "off" and the p-channel transistor 2 turns "on", so that H level appears at the output. In this manner, in the C-MOS circuit, in either of the "on" and "off" states of the gate, one of the two transistors is "off" and a current path from the power source to ground level is not formed. Accordingly, the C-MOS circuit has the feature of very low power consumption. Regarding the operating current, currents of equal values alternately flow through the n-channel and p-channel transistors during the "on" and "off" states of the gate as illustrated in Figs. 2B and 2C. Therefore, both the charging and discharging processes of a load capacitance 4 can be performed with large currents, and a C-MOS circuit can offer improved switching speed. Since, however, a C-MOS circuit requires transistors of both polarities, n-channel and p-channel as stated above, its manufacture usually becomes very complicated, and a decrease in the available percentage (manufacturing yield), and a rise in cost, etc. are inevitable.

With enhancement in the functions of integrated circuits and increase in the scale of integration thereof, the features of higher speed and higher density of integration have been eagerly pursued. To this end, a circuit form which has a power consumption sufficiently low, which provides high-speed operation and a high density of integration, and the manufacture of which is simple, is needed.

According to the present invention there is provided a logic circuit comprising a first logic gate, comprising at least one logic gate circuit having a plurality of logical input terminals, and a second logic gate, comprising at least one logic gate circuit to which a logical output signal of the first logic gate is applied, the second logic gate having at least one driving field-effect transistor (FET), and load FET's at least equal in number to the logical input terminals of the first logic gate, the said at least one driving FET being connected between a logical output terminal of the second logic gate and one power-source terminal, and having its gate terminal connected to receive the logical output signal of the first logic gate means, the load FET's being connected between the logical output terminal of the second logic gate and another power-source terminal, and having their gate terminals connected with corresponding logical input terminals of the first logic gate means.

According to the present invention there is provided a logic circuit having a plurality of unit logic gate circuits, each unit logic gate circuit comprising at least one driving field-effect transistor (FET) means and at least one load FET means, the driving and load FET means being in series between supply voltage-feeding terminals, a signal output end of one unit logic gate circuit being connected to an input terminal of the driving transistor means of another unit logic gate circuit, a signal input end of the said one unit logic gate circuit, capable of affording an inverted signal at a signal output end thereof, being connected to an input terminal of the load transistor means in the said other unit logic gate circuit, characterised in that the load FET means is composed of an enhancement-mode FET and a depletion-mode FET whose sources, drains and gates are respectively connected in common.

An embodiment of this invention can provide a logic circuit of high operating speed and low power consumption, and can further provide a logic circuit of high operating speed and low power consumption which is capable of multistage connection.

An embodiment of this invention provides a logic circuit in which an output of a first logic circuit having a plurality of inputs is applied to a first input of a second logic circuit, and a plurality of input signals entering the first logic circuit are applied to a plurality of second inputs of the second logic circuit, whereby high operating speed and low power consumption can be provided.

An embodiment of the present invention can further provide a logic circuit in which FET's connected to a power source consist of an enhancement-mode FET and a depletion-mode FET having their sources, drains and gates connected in common, respectively, whereby the logic circuit is capable of multistage connection.

Reference is made, by way of example, to the accompanying drawings, in which:-

Figures 1A and 1B are circuit diagrams illustrating respective previously proposed logic circuits, whilst Figure 1C is a graph illustrating characteristics of the logic circuits of Figures 1A and 1B;

Figure 2A is a circuit diagram of another previously proposed logic circuit, whilst Figures 2B and 2C are graphs illustrating characteristics of the logic circuit of Fig. 2A;

Figure 3 is a circuit diagram of a logic circuit of high operating speed;

Figure 4 is a time chart for assistance in explaining the operation of the logic circuit of Fig. 3;

Figures 5 and 6 are circuit diagrams illustrating respective applications of the logic circuit of Figure 3;

Figures 7, 8, 9 and 10 are circuit diagrams of respective embodiments of this invention;

Figure 11 is a circuit diagram for assistance in explaining a problem which can arise with multistage connection of logic circuits;

Figure 12 is a circuit diagram showing another embodiment of this invention;

Figure 13 is a plan structural view illustrating an integrated logic circuit embodying this invention; and

Figures 14, 15, 16 and 17 are circuit diagrams of respective further embodiments of this invention.

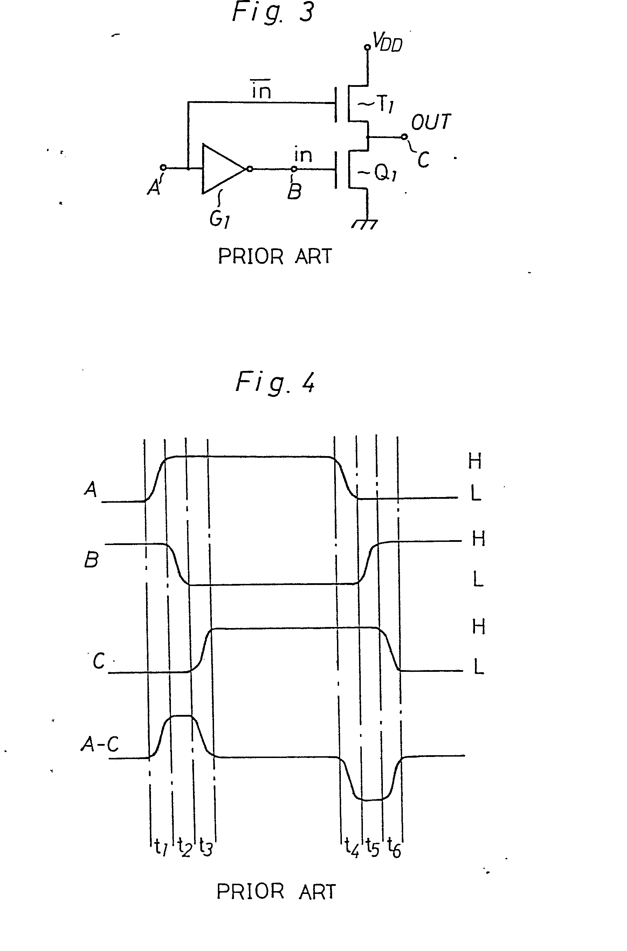

Figure 3 is a diagram of a known inverter circuit which has a high operating speed. $Q_1$ designates a driving MOS transistor, and $T_1$ a load MOS transistor. While both the transistors are of the enhancement mode here, the load transistor $T_1$ may alternatively be of the depletion mode, as will be described later. $G_1$ indicates a gate circuit at the preceding stage for applying a signal to the inverter circuit. The output signal terminal of the preceding-stage gate circuit $G_1$ is connected to the gate terminal of the driving transistor $Q_1$, whilst the input signal terminal of the preceding-stage gate circuit $G_1$ is connected to the gate terminal of the load transistor $T_1$. Accordingly, complementary input signals are applied to the gate terminals of the respective transistors $Q_1$ and $T_1$ with a phase shift which corresponds to the propagation delay time of the preceding-stage gate circuit $G_1$. Except for the connection arrangement on the input side, the driving and load transistors $Q_1$ and $T_1$ are connected in series with one another between a power source voltage $(V_{DD})$ feed terminal and a ground terminal in a conventional fashion. The junction between the two transistors, namely, the node between the drain terminal of the driving transistor $Q_1$ and the source terminal of the load transistor $T_1$ is used as a signal output terminal.

The operation of the circuit in Figure 3 will now be described. First, steady-state logical operation is as follows. When the gate terminal of the driving transistor

$Q_1$ (point B in Figure 3) is at a low (L) level, the input
terminal of the preceding-stage inverter circuit $G_1$ (point
A in Figure 3) is at a high (H) level, and the H level is
applied to the gate terminal of the load transistor $T_1$. At
this time, the transistor $Q_1$ is in the "off" state and the
transistor $T_1$ is in the "on" state, so that H level, based
on the power source voltage $V_{DD}$, appears at the output
terminal (point C in Figure 3) through the load transistor
$T_1$. In contrast, when the point B is at H level, the point
A is at the L level, and the transistor $Q_1$ turns "on" and
$T_1$ turns "off", so that L level appears at the point C.
These logical operations are summarised in the following
table 1:

Table 1

| A | B | $Q_1$ | $T_1$ | C |
|---|---|-------|-------|---|
| H | L | off | on | H |
| L | H | on | off | L |

The relationship between levels is one of inversion
between the level at point B, being the signal input end
of the inverter circuit, and the level at point C, being
the signal output end, so that inverting operations are
attained. To be especially noted in the operation of the
circuit is that, with either of the input levels (H or L),
one of the transistors $Q_1$ and $T_1$ is in a non-conductive
state steadily without fail. This indicates that, in the
steady state, current flowing from the power source voltage

($V_{DD}$) feed terminal to the ground terminal is substantially null, only an infinitesimal leakage current flowing during non-conduction between the two terminals. Thus, unlike the previously proposed E/E type and E/D type circuits, the power consumption of the circuit of Figure 3 is very low. In other words, the circuit of Fig. 3 has an ideal operation, similar to that of a C-MOS circuit, as a switching circuit. Further, a C-MOS circuit needs transistors of both polarities, n-channel and p-channel, and requires isolation between the elements, etc., resulting in a manufacturing process of considerable complexity and a low density of integration. In contrast, the circuit of Figure 3 can be constructed of transistors of a single polarity. Therefore, the circuit of Figure 3 is superior to a C-MOS circuit so far as ease of manufacture and packaging density are concerned.

There is a push-pull type circuit which is apparently similar in arrangement to the above logic circuit. This push-pull type circuit is employed in an output buffer, etc. This circuit is so arranged that an input signal from a signal input end is inverted by an inverter circuit and the inverted input signal is applied to the gate terminal of an MOS transistor on the load side. In steady state conditions, one of a driving transistor and a load transistor is normally held in a non-conductive state, and the other in a conductive state. Thus, as in a C-MOS circuit or in the circuit of Figure 3, power consumption is reduced, or load drivability is enhanced.

The push-pull type circuit, however, needs an added inverter circuit and is clearly different from the simple arrangement of Figure 3 in which an inverted signal is obtained from the input end of the preceding-stage gate circuit. In addition, in the push-pull type circuit, the signal which is applied to the gate terminal of the load transistor has a phase lag corresponding to the delay time of the inverter circuit, with respect to the input signal to the driving transistor. The phase shift relationship is the reverse of that of the circuit of Figure 3. That is, in a case in which the output changes from the L level to the H level, by way of example, in the circuit of Figure 3 the load transistor turns "on" and then the driving transistor turns "off" in the circuit of Figure 3, whereas the driving transistor turns "off" and then the load transistor turns "on" in the push-pull type circuit described above. In the push-pull type circuit, both the load transistor and the driving transistor can be turned "off" in this manner, which indicates that the change of output from L level to H level is slow. On the basis of such phase shift relationship, the circuit of Figure 3 has a superior operating speed characteristic as compared with the push-pull type circuit or with the conventional E/E type or E/D type circuit and even as compared with the C-MOS circuit.

The high operating speed of the circuit of Figure 3 is based not only on the phase shift relationship described above, but also on the fact that charging and discharging currents for a load capacitance during switching transient periods can be made large. The details of the reason for this will be apparent from the following description of transient operation.

Figure 4 is a time chart showing potential variations at points A, B and C in the circuit of Figure 3 and showing the variation of the potential difference A-C between point A and point C. Here it will be assumed that an operation is taking place when the preceding-stage gate circuit $G_1$ is connected to a gate circuit of the further preceding stage having the same arrangement as that of the circuit of Figure 3. First, it is assumed that initially the point A is at L level. The point B, being the signal input terminal of the inverter circuit in Figure 3, is at H level. Accordingly, the point C at the output end becomes L level, and the potential difference A-C between the gate and source of the load transistor $T_1$ is 0 (zero). Assuming that the level of the point A rises from L to H, this level change precedes by a time interval $t_1$, corresponding to the delay time of the preceding-stage inverter circuit $G_1$, the timing at which the point B, being the signal input end, starts to shift from H level to L level. During a time interval $t_2$ in which the point B shifts to L level and the driving transistor $Q_1$ turns "off", the level of the output end or the point C remains low. During the periods $t_1$ and $t_2$, therefore, the potential difference between the gate and source of the load transistor $T_1$ is at high level, and the load transistor $T_1$ is in the conductive state. For the rise in level of the point C, being the output end, accordingly, a sufficiently great current can be supplied as charging current of the load capacitance through the load transistor $T_1$ which is already in the conductive state. Therefore, the level of the output end rises rapidly in a period $t_3$. Thus, switching speed is remarkably enhanced. When the potential of the point C, being the output end, has risen sufficiently, the gate-source potential difference of the load transistor $T_1$ becomes sufficiently small, and this transistor falls into a substantially "off" state. In practice, the potential of the point C, being the output end, can rise only to a potential which is lower by a gate threshold voltage than the potential of the gate terminal of the load transistor $T_1$. It is therefore desirable to make the gate threshold value of the load transistor $T_1$ zero or to make it of small value close to zero.

Subsequently, when the level of the point B, being the signal input end, is to start its rise, the potential of the point A falls in a preceding period $t_4$. Thus, the gate potential of the load transistor $T_1$ becomes lower than the level of the source potential thereof, namely, the potential of the point C, and this transistor falls into a perfectly non-conductive state. In this state, the level of the point B or the gate terminal potential of the driving transistor $Q_1$ rises during a time interval $t_5$, charges in the load capacitance are discharged through the driving

transistor $Q_1$ having reached the conductive state, and the level of the point C, being the output end, rises during a time interval $t_6$. Meantime, the load transistor $T_1$ is perfectly non-conductive. Therefore, the driving transistor $Q_1$ in the "on" state discharges the stored charges of the load capacitance rapidly, thereby to lower the level of the output end point C at high speed.

As will be apparent from the above description of transient operation, with the circuit of Figure 3, a signal the inverse of the input signal to the driving transistor is applied in advance to the gate terminal of the load transistor $T_1$, whereby the charging and discharging of the load capacitance are quickly effected to achieve a high-speed switching operation. Such operation is basically similar to C-MOS circuit operation, and charging and discharging currents of the load capacitance at switching can be made to achieve values which are, for example, 10 or more times greater than in the E/E type circuit or the E/D type circuit. With a C-MOS circuit, even in an ideal case, the on-off switching operations of the p-channel and n-channel MOS transistors take place simultaneously at the utmost. From the transient viewpoint, the circuit of Figure 3 can make the charging and discharging currents greater immediately after the initiation of charging and discharging of the load capacitance, and it can realise an operation of higher speed.

With the push-pull type inverter circuit mentioned above, the phase of the gate input signal to the load side transistor lags the delay time component provided by the inverter circuit. Therefore, the effect of increasing the charging and discharging currents of the load capacitance during transient operations does not occur at all.

In the foregoing description of operations, each of the time intervals $t_1$ - $t_6$ corresponds to a delay time per gate stage. As already stated, if the preceding-stage gate circuit $G_1$ or the preceding-stage gate circuit anterior thereto has the same arrangement as that of the logic gate circuit in Figure 3, its delay times $t_1$, $t_2$ or $t_4$, $t_5$ will be identical to the delay times $t_3$, $t_4$.

Although, in the circuit of Figure 3, the load transistor $T_1$ is an enhancement-mode MOS transistor, it may equally well be of depletion mode. In a case in which the load transistor is of the depletion mode, a steady state in which current flows through the load transistor steadily is provided, but charging capability for the load capacitance is further enhanced and a still higher operating speed can be realised. Also in this case, the inverted signal is impressed on the gate terminal of the load transistor before the input signal is applied to the gate circuit, and at switching, the conductance of the load transistor is changed in advance in directions suitable for the rapid charging and discharging operations of the load capacitance, whereby a high-speed operation is achieved.

As set forth above, the circuit of Figure 3 has the ideal operating mechanism in which the driving and load transistors switch "on" and "off" alternately as in the C-MOS circuit, and it has the special feature of high-speed operation at very low power consumption as compared with the E/E type circuit and the E/D type circuit. On the other hand, since it can be constructed of transistors of only a single polarity, it does not involve the problems of complicated manufacturing processes, reduced density of integration due to a requirement for isolation between the elements, and malfunctions attributed to parasitic thyristor action, etc., as with a C-MOS circuit. Accordingly, the circuit of Figure 3 has ideal characteristics and properties as a logic integrated circuit.

While the circuit of Figure 3 is an inverter circuit which is the basic gate of logic circuit, a logic gate circuit with a plurality of inputs having an AND function and an OR function is needed in order actually to perform complicated logical functions. To apply the circuit of Figure 3 to a multi-input logic gate circuit, special contrivances are further required.

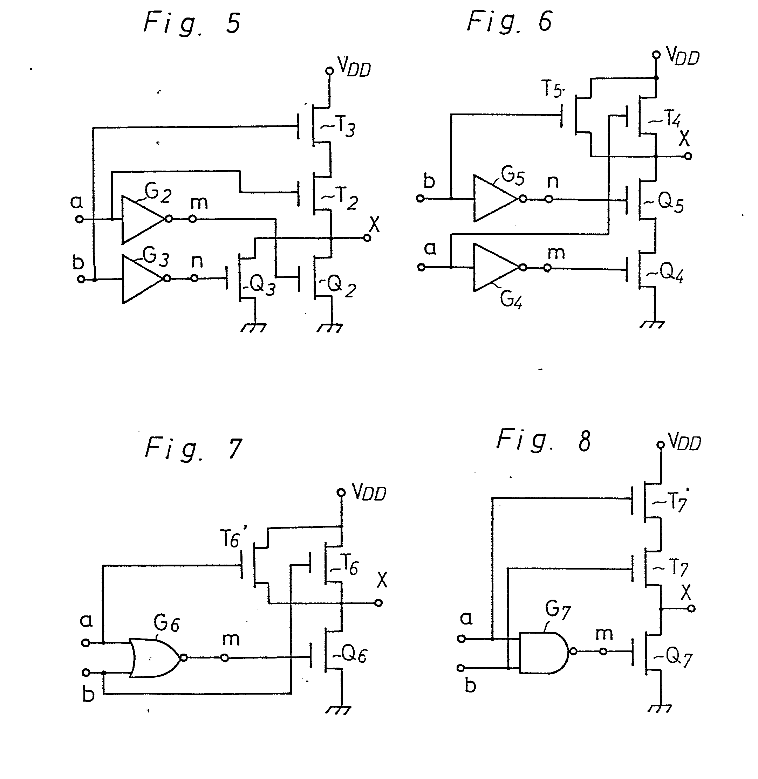

A 2-input NOR gate circuit in which the circuit of Figure 3 is applied is shown in Figure 5. Although the number of inputs is two in the case of Figure 5, it is to be understood from the ensuing description that the arrangement can be extended to a multi-input arrangement having three or more inputs.

Referring to Figure 5, $Q_2$ and $Q_3$ designate driving transistors which are connected to ground side in parallel with one another, and $T_2$ and $T_3$ designate load transistors which are connected to the power source ($V_{DD}$) side in series with one another. In the present example, all these transistors are enhancement-mode MOS transistors. $G_2$ and $G_3$ designate preceding-stage gate circuits which apply signals to the inputs m and n of the 2-input NOR gate respectively, and which are illustrated as inverter circuits in this case. The output terminals m and n of the preceding-stage gates $G_1$ and $G_2$ are respectively connected to the driving transistors $Q_2$ and $Q_3$, whilst the inputs a and b of the preceding-stage gate circuits $G_2$ and $G_3$ are respectively connected to the gate terminals of the load transistors $T_2$ and $T_3$. The output terminal X of this NOR gate circuit is provided at the node between the drains of the driving transistors $Q_2$ and $Q_3$. With this circuit arrangement, the outputs of the preceding-stage gates are applied to the gate terminals of the driving side transistors. Input signals which are inverted with respect to the outputs of the preceding-stage gates are applied to the load side transistors. Therefore, the driving elements and the load elements can be set in the opposite states ("on" and "off") without fail, and an ideal switching operation is attained. The operations of the NOR circuit are tabulated in the following table 2:

Table 2

| a | b | m | n | $Q_2$ | $Q_3$ | $T_2$ | $T_3$ | X |
|---|---|---|---|-------|-------|-------|-------|---|
| H | H | L | L | off | off | on | on | H |
| H | L | L | H | off | on | on | off | L |
| L | H | H | L | on | off | off | on | L |
| L | L | H | H | on | on | off | off | L |

From this table, it will be clear that the circuit of Figure 5 functions to produce a NOR output X in response to inputs m and n.

Now, a 2-input NAND circuit in which the circuit of Figure 3 is applied is shown in Figure 6. Also in regard to Figure 6, although only two inputs are shown, it is a matter of course that the number of inputs can be readily increased to three or more. Referring to Figure 6, $Q_4$ and $Q_5$ are enhancement-mode MOS driving transistors which are connected in series, whilst $T_4$ and $T_5$ are load transistors which are connected in parallel between a power source terminal $V_{DD}$ and an output terminal X. $Q_4$ and $Q_5$ represent preceding-stage gate circuits, the output ends m and n of which are respectively connected to the gates of the driving transistors $Q_4$ and $Q_5$ being the signal input ends of the NAND circuit and the inputs a and b of which are respectively connected to the gate terminals of the load transistors $T_4$ and $T_5$. Owing to this arrangement, similarly to the NOR gate circuit of Figure 5, logical signals which are opposite in level (H or L) are applied respectively to the driving elements and the load elements. In addition, transient signals are applied to the load elements earlier in time than the signals are applied to the driving elements, by an interval corresponding to one logic gate stage. The circuit arrangement of Figure 6 operates in steady state with signal statuses as indicated in Table 3 below, and it will be understood that a NAND function is provided. Except for transient operation, a transistor in the "off" state is always interposed between the supply voltage $V_{DD}$ and the ground potential, so that the power consumption becomes very low. Further, charging and discharging of load capacitance can proceed quickly during the transient operation, so that the switching operation is carried out at high speed.

Table 3

| a | b | m | n | $Q_4$ | $Q_5$ | $T_4$ | $T_5$ | X |
|---|---|---|---|-------|-------|-------|-------|---|
| H | H | L | L | off | off | on | on | H |
| H | L | L | H | off | on | on | off | H |
| L | H | H | L | on | off | off | on | H |
| L | L | H | H | on | on | off | off | L |

As apparent from the above description, not only the inverter circuit of Figure 3, but also a multi-input NOR gate circuit or multi-input NAND gate circuit having any desired number of inputs can be provided by appropriately applying the circuit of Figure 3. Accordingly, any desired logical function can be realised by properly combining such circuits.

The foregoing circuits, however, have been usable only for data passed through an inverter. It has not been applicable to, for example, (data passed through) a NAND circuit, a NOR circuit etc. because a logic circuit at the preceding stage has a plurality of inputs. This has been a serious problem when a large number of logic circuits have required to be integrated. That is, each of most logic circuits includes NAND circuits, NOR circuits etc., and it is meaningless to enhance the operating speed of a part of a logic circuit. This invention provides a logic circuit which can enhance operating speed, not only for the signal of the prior-art inverter circuit, but also for logic circuits such as a NAND circuit and NOR circuit.

Figure 7 shows the circuit of a first embodiment of the present invention, being an inverter circuit in which a 2-input NOR gate circuit $G_6$ is a preceding-stage gate circuit. Even in a case in which the preceding-stage NOR gate circuit $G_6$ has three or more inputs, an arrangement embodying the present invention may be provided which is similar to the arrangement of Figure 7. In Figure 7, $Q_6$ is a driving transistor which is operated by the output of the NOR gate $G_6$. $T_6$ and $T_6'$ are load transistors which are connected in parallel with one another and the gate terminals of which are respectively supplied with the inputs b and a of the preceding-stage NOR gate $G_6$. As a result, the load elements $T_6$ and $T_6'$ are supplied with two signals which precede in time an input signal applied at a point m, being the input end of the present inverter circuit, by a component (time period) corresponding to one stage of the NOR gate $G_6$, and at least one of which signals is inverted with respect to the signal at point m. Accordingly, as will be apparent from the following table 4 indicative of the logic operations of the present circuit, any of the driving transistor $Q_6$ and the load transistors $T_6$ and $T_6'$ is infallibly in the "off" state in a path extending from a supply voltage $V_{DD}$ to the ground potential, and the circuit operates so as to block the current path:

Table 4

| a | b | m | $Q_5$ | $T_6$ | $T_6'$ | X |
|---|---|---|-------|-------|--------|---|
| L | L | H | on | off | off | L |
| L | H | L | off | on | off | H |
| H | L | L | off | off | on | H |
| H | H | L | off | on | on | H |

Now, as another example of connection from a multi-input gate, a second embodiment of the present invention, in which an inverter is driven with outputs from a 2-input NAND gate, will be described with reference to Figure 8. It will be readily understood that the example of Figure 8 can of course be extended to an arrangement whose preceding-stage is a multi-input NAND gate having three or more inputs. In Figure 8, $Q_7$ is a driving transistor, $T_7$ and $T_7'$ are load transistors, and $G_7$ is a 2-input NAND gate circuit. The difference between the circuit connection arrangement of Figure 8 and that of the embodiment of Figure 7 is that the load transistors $T_7$ and $T_7{}'$ are connected in series and that during a steady operation, any of the transistors $Q_7$, $T_7$ and $T_7{}'$ is infallibly in the "off" state and makes very high the impedance of the current path between a power source $V_{DD}$ and the ground. The logical operations of the circuit in Figure 8 are listed in the following table 5:

Table 5

| a | b | m | $Q_7$ | $T_7$ | $T_7{}'$ | X |
|---|---|---|-------|-------|----------|---|
| L | L | H | on | off | off | L |
| L | H | H | on | on | off | L |
| H | L | H | on | off | on | L |
| H | H | L | off | on | on | H |

As will be understood from the above description of two kinds of circuits, in a case in which a logic circuit, in which a mult-input logic gate circuit is a preceding-stage gate circuit, is arranged in accordance with the present invention, load transistors equal in number to the inputs of the preceding-stage gate circuit may be disposed in such a manner that the input terminals of the preceding-stage gate circuit are respectively connected to the gate terminals of the load transistors. When the preceding-stage gate circuit is a NOR circuit, tha load transistors are connected in parallel with one another, and when it is a NAND circuit, they are connected in series. Thus, the merits of this invention; a very low power consumption and a high-speed switching operation are attained irrespective of the number of inputs of the preceding-stage gate circuit.

The embodiments of the present invention shown in Figures 7 and 8 correspond to a case in which an inverter function is realised by the load transistors and the driving transistor.

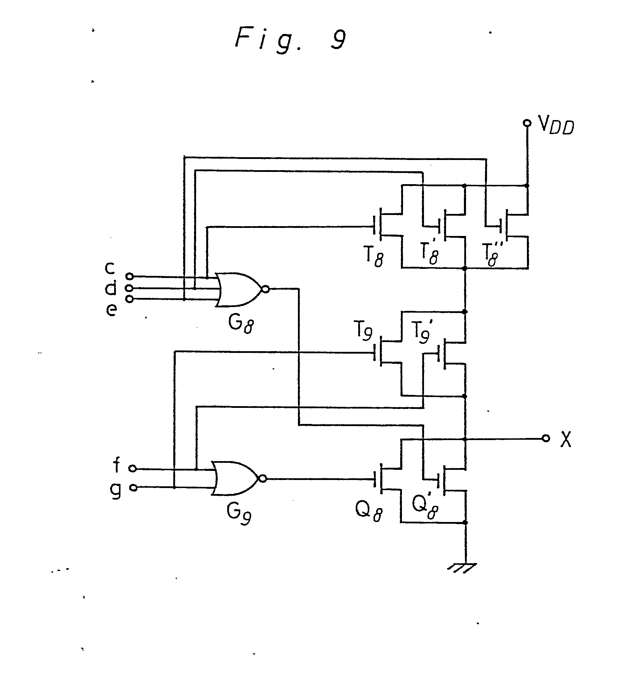

Now, cases in which logic circuits embodying this invention are used to realise NOR and NAND functions will be described. Figure 9 shows a third embodiment of the present invention in which preceding-stage circuits are a 3-input NOR circuit $G_8$ and a 2-input NOR circuit $G_9$ and which provides NOR OR logic between the outputs of the NOR circuits $G_8$ and $G_9$. The drains and sources of load transistors $T_8$, $T_8'$ and $T_8''$ are respectively connected in common. The gates of the load transistors $T_8$, $T_8'$ and $T_8''$ are respectively connected to input terminals $c$, $d$ and $e$ which are connected to the inputs of the NOR circuit $G_8$. Likewise, the drains and sources of load transistors $T_9$ and $T_9'$ are respectively connected in common, and the gates thereof are respectively connected to input terminals $g$ and $f$ which are connected to the inputs of the NOR circuit $G_9$. The drains and sources of driving transistors $Q_8$ and $Q_8'$ are respectively connected in common, and the gates thereof are respectively connected to the outputs of the NOR circuits $G_9$ and $G_8$. The load transistors $T_8$, $T_8'$ and $T_8''$ have their drains connected to a power source $V_{DD}$, and have their sources connected to the drains of the load transistors $T_9$

and $T_9'$. The driving transistors $Q_8$ and $Q_8'$ have their drains connected to an output terminal X and also to the sources of the load transistors $T_9$ and $T_9'$, and they have their sources grounded. When all the inputs c, d and e are of L level, all the load transistors $T_8$, $T_8'$ and $T_8''$ turn "off", and current from the power source is cut off. At this time, the driving transistor $Q_8'$ turns "on", and the output becomes L level. Similarly, when both the inputs f and g are of L level, both the load transistors $T_9$ and $T_9'$ turn "off", and the current from the power source is cut of At this time, the driving transistor $Q_8$ turns "on", and the output becomes L level. However, in the case where at least one of the inputs c, d and e is of H level, and where at least either of the inputs f and g is of H level, both the outputs of the NOR circuits $G_8$ and $G_9$ become L level, and the driving transistors $Q_8$ and $Q_8'$ turn "off". At this time, at least one of the load transistors $T_8$, $T_8'$ and $T_8''$ turns "on" and at least one of the load transistors $T_9$ and $T_9'$ turns "on", so that the output X becomes H level. In this manner, in the third embodiment of the present invention, when the supply voltage is provided at the output X through the load transistors $T_8$, $T_8'$ and $T_8''$ and the load transistor $T_9$ and $T_9'$, both the driving transistors $Q_8$ and $Q_8'$ are "off". In the reverse case, that is, when at least one of the driving transistors $Q_8$ and $Q_8'$ is "on", all the load transistors $T_8$, $T_8'$ and $T_8''$ are "off" or both the load transistors $T_9$ and $T_9'$ are "off". During the steady state, therefore, no power is consumed within the circuit.

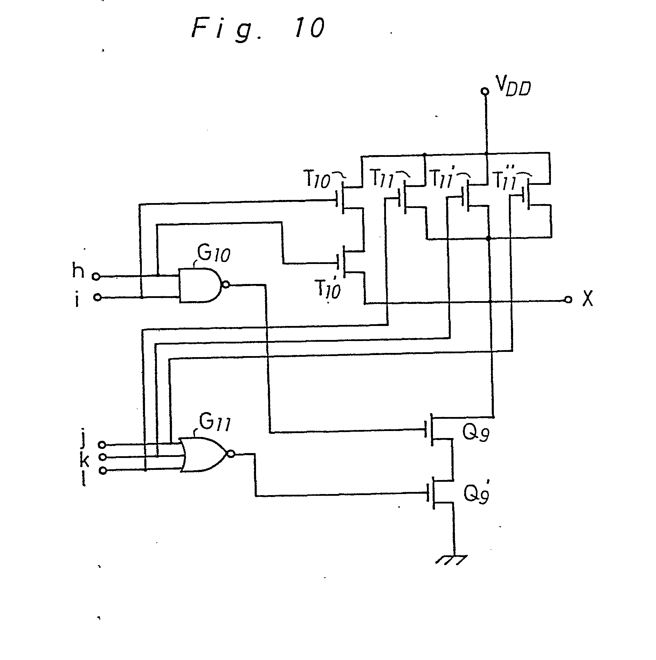

Figure 10 shows a fourth embodiment of the present invention. In this fourth embodiment, preceding-stage circuits are a 2-input NAND circuit $G_{10}$ and a 3-input NOR circuit $G_{11}$, and NOT AND logic between the outputs of the circuits $G_{10}$ and $G_{11}$ is provided at the output of the fourth embodiment. A load transistor $T_{10}$ has its drain connected to a power source $V_{DD}$, and has its source connected to the drain of a load transistor $T_{10}'$. The gates of these load transistors $T_{10}$ and $T_{10}'$ are respectively connected to inputs $i$ and $h$ with which the inputs of the NAND circuit $G_{10}$ are connected. The sources and drains of load transistors $T_{11}$, $T_{11}'$ and $T_{11}''$ are respectively connected in common, and the drains are connected to a power source $V_{DD}$. Further, the gates of the load transistors $T_{11}$, $T_{11}'$ and $T_{11}''$ are respectively connected to inputs $l$, $k$ and $j$ with which the inputs of the NOR circuit $G_{11}$ are connected. The gates of driving transistors $Q_9$ and $Q_9'$ are respectively connected to the outputs of the NAND circuit $G_{10}$ and the NOR circuit $G_{11}$. The drain of the driving transistor $Q_9$ is connected to the source of the load transistor $T_{10}'$ and also to the sources of the load transistors $T_{11}$, $T_{11}'$ and $T_{11}''$. The driving transistor $Q_9'$ has its drain connected to the source of the driving transistor $Q_9$, and has its source grounded. In the circuit of the fourth embodiment, no steady current flows as in the first, second and third embodiments described before. More specifically, when at least one of the inputs of the NOR circuit $G_{11}$ is of H level, the driving transistor $Q_9'$ turns "off", and conversely at least one of the load transistors $T_{11}$, $T_{11}'$ and $T_{11}''$ turns "on", so that the output X becomes H level. When both the inputs $h$ and $i$ are of H level, the output of the AND circuit $G_{10}$ becomes L level, with the result that the driving transistor $Q_9$ turns "off". At this time, both the load transistors $T_{10}$ and $T_{11}$ are "on", so that the output X becomes H level. Contrariwise, in the case where all the inputs $j$, $k$ and $l$ are of the L level and where at least one of the inputs $h$ and $i$ is of the L level, both the driving transistors $Q_9$ and $Q_9'$ turn "on". At this time, all the load transistors $T_{11}$, $T_{11}'$ and $T_{11}''$ are "off" and one of the load transistors $T_{10}$ and $T_{10}'$ is "off", so that current does not flow through the driving transistors via the load transistor. In this manner, therefore, in the fourth embodiment of the present invention, no power is consumed in the steady state, and an integrated circuit of low power consumption is realisable.

The "on" and "off" timings of the first, second, third and fourth embodiments are the same as the "on" and "off" timings of the load transistor and the driving transistor in the prior-art circuit shown in Figure 3, and the operating speed is rendered high.

In each of the first to fourth embodiments of this invention, examples of logic circuits are given, and any kind of logic circuit can be used as the preceding-stage logic circuit. Further, circuits of all logical forms can be realised by appropriately combining load transistors and driving transistors.

In the foregoing description of embodiments of this invention, use in a multi-stage connection has not been explicitly described. When embodiments of this invention are connected in cascade in a plurality of stages, a problem can arise in some cases in practical use that the signal level is reduced.

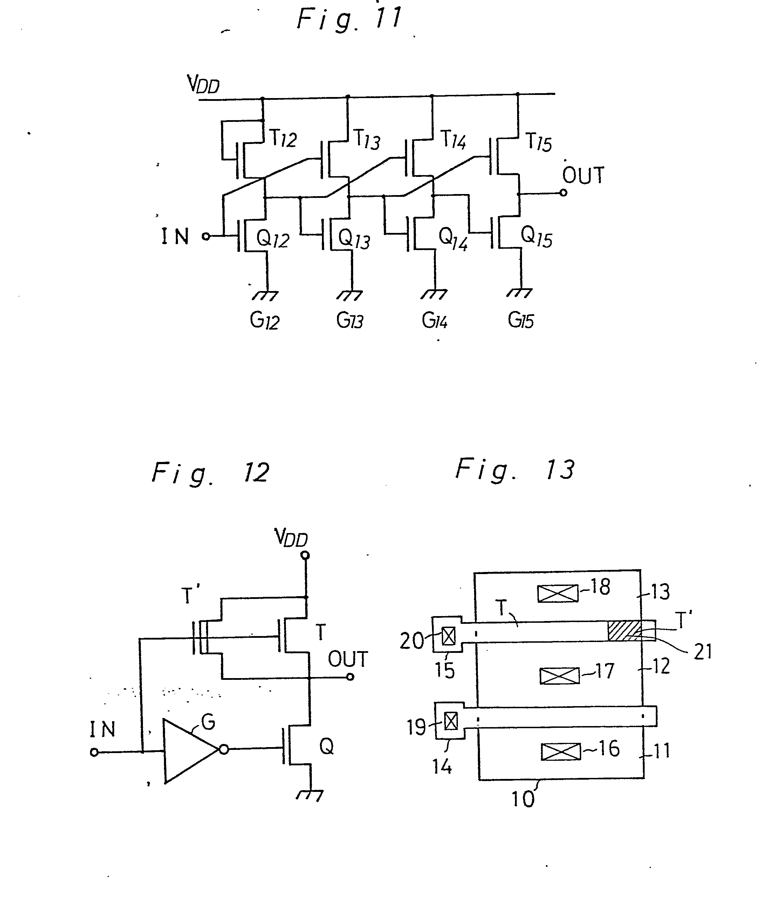

This problem will be explained with reference to Figure 11. Figure 11 shows an example of a circuit in which inverter gate circuits $G_{12}$ - $G_{15}$ are connected in cascade. The inverter circuit $G_{12}$ of the first stage is of the conventional E/E type, whereas the second stage $G_{13}$ and the succeeding stages are constructed on the basis of a fundamental circuit arrangement embodying the present invention. $Q_{12}$ - $Q_{15}$ designate driving transistors, and $T_{12}$ - $T_{15}$ are enhancement-mode MOS transistors for loads. They are assumed to have common gate threshold values $V_{th}$, respectively.

In the logic circuit of Figure 11, when an L level signal substantially equal to the ground potential is applied to an input end IN, the output of the inverter circuit $G_{12}$ at the first stage becomes H level. As is well known, the actual potential of the H level is a potential $(V_{DD} - V_{th})$ which is lower than the supply voltage $V_{DD}$ applied to the gate of the load transistor $T_{12}$, by the

threshold value $V_{th}$ of this transistor. The L level input of the first-stage gate $G_{12}$ is applied to the gate of the load transistor $T_{13}$ of the second-stage gate $G_{13}$ and brings this transistor into the "off" state. On the other hand, the output signal of the level $(V_{DD} - V_{th})$ is also applied to the gate of the driving transistor $Q_{13}$. Accordingly, when the gate threshold value of the driving transistor $Q_{13}$ is smaller than the output signal level $(V_{DD} - V_{th})$, the transistor $Q_{13}$ turns "on", and an L level signal substantially equal to the ground potential is provided at the output end of the second-stage gate $G_{13}$. In the subsequent third-stage gate $G_{14}$, the L level signal substantially equal to the ground potential is applied to the gate of the driving transistor $Q_{14}$, so that the transistor $Q_{14}$ falls into the "off" state. On the other hand, the gate of the load transistor $T_{14}$ is supplied with the output signal of the first-stage gate $G_{12}$, the level of this signal being $(V_{DD} - V_{th})$. Therefore, the output end potential of the third-stage gate $G_{14}$ rises, but only a level $(V_{DD} - 2 V_{th})$, which is still lower than the gate potential of the transistor $T_{14}$ by $V_{th}$, is obtained as the output potential.

Quite similarly to the above, when an ordinary H level signal of $(V_{DD} - V_{th})$ is applied to the first-stage gate $G_{12}$ , signals levels lower in succession are provided in such a manner that the output of the second stage $G_{13}$ which ought to be H level becomes $(V_{DD} - 2 V_{th})$ and that

the output of the fourth stage $G_{15}$ becomes $(V_{DD} - 3\ V_{th})$. Eventually, there can occur the situation in which even an H level signal cannot turn "on" the driving transistor of the succeeding stage.

This problem of the reduction of signal level can be eliminated by, for example, employing depletion-mode transistors as load transistors. In that case, however, it is difficult to attain the effect of a marked reduction in power consumption by providing that either the load element or the driving element is infallibly brought into the non-conductive state in steady state conditions.

In embodiments of this invention, therefore, with a view to solving the above problem, load elements are constructed of an enhancement-mode transistor and a depletion-mode transistor whose sources, drains and gates are respectively connected in common.

Figure 12 is a circuit diagram showing the fifth embodiment of the present invention which provides a logic circuit employing such load elements. The embodiment is such that the construction of the load elements is applied to a fundamental circuit arrangement in which two inverter circuits are connected in cascade as in the example of Figure 3. With reference to Figure 12, Q is a driving transistor, T and T' are enhancement-mode and depletion-mode MOS transistors for loads, respectively, and G designates an inverter circuit at the preceding stage. As will be understood from the above description, the depletion-mode load transistor T' is intended to refresh the signal level, and its gate threshold value assumes a negative value (in case of the n-channel type). That is, the depletion-mode load element T' is provided for the purpose of raising the output level of the logic circuit of Figure 12 up to a supply voltage $V_{DD}$ in a state in which the logic circuit steadily provides H level. The purpose can be achieved only if the element T' is capable of causing a slight current to flow. On the other hand, in the logical status which ought to deliver L level, that is, in the state in which H level is applied to the gate terminal of the driving transistor Q and L level is applied to the load transistors T and T', current flows through the depletion-mode load transistor T' as well as through the driving transistor Q, and power consumption is induced. It is therefore desirable that the current permitted to flow through the depletion-mode load element T' be limited to a comparatively small value. It is therefore desirable to make the gate width of the depletion-mode load element smaller than that of the driving transistor Q.

Since the enhancement-mode load element T is a load transistor for the original push-pull operation, it has its current capacity made large in order to permit a high-speed transient change. To this end, the gate width of the load element T is made approximately equal to that of the driving element Q. In this case, it does not arise in the steady state that both the enhancement-mode load element T and the driving transistor Q fall into the "on" states, and excess power consumption is not brought about thereby.

In this manner, a second feature of embodiments of the present invention consists in that an enhancement-mode load is employed in the fundamental operation in order to realise low power consumption and high operating speed through push-pull operation, whilst a depletion-mode load of small current capacity is employed in order to refresh the signal level, in other words, in order to provide a level not affected by the gate threshold value. Although the load elements may well be constructed by interconnecting discrete enhancement-mode and depletion-mode transistors, a unitary load element is readily fabricated within an integrated circuit. The plan structure of a practicable unitary element in a sixth embodiment of the present invention is shown in Figure 13.

Shown in Figure 13 is an example of a practicable plan structure of a portion which corresponds to one stage of an inverter circuit embodying this invention. 10 is an element' region which is surrounded with a field region, 11 is a source region of a driving element (n-channel type MOS transistor), 12 is a region which serves both as a drain region of the driving element and as a source region of a load element, 13 is a drain region of the load element, 14 is a gate electrode of the driving element, and 15 is the gate electrode of the load element. 16, 17 and 18 are connection portions for a ground lead, an output end lead and a power source ($V_{DD}$) lead, respectively. 19 and 20 are connection portions for leads from the output end and input end of a preceding-stage gate circuit, respectively. It is a feature of the structure of the present embodiment of this invention that the load element has its greater part fabricated similarly to an enhancement-mode MOS transistor, but that it is fabricated so as to exhibit depletion characteristics in a part region 21. The formation of the depletion region 21 is easy. For example, in case of an n-channel type MOS transistor, the ions of a donor impurity such as arsenic may be injected by the use of an appropriate mask such as photoresist layer for exposing the region 21, so as to form a thin n-type layer in a part surface under the gate electrode 15.

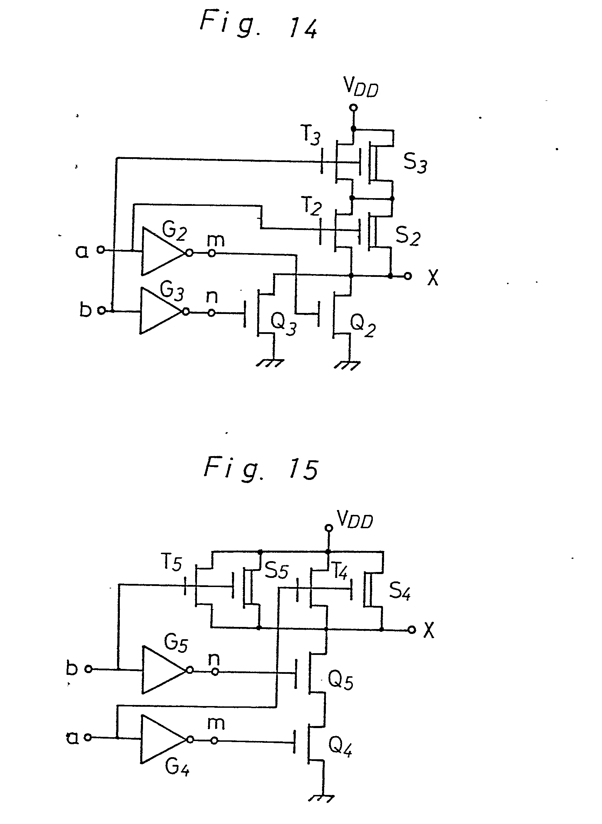

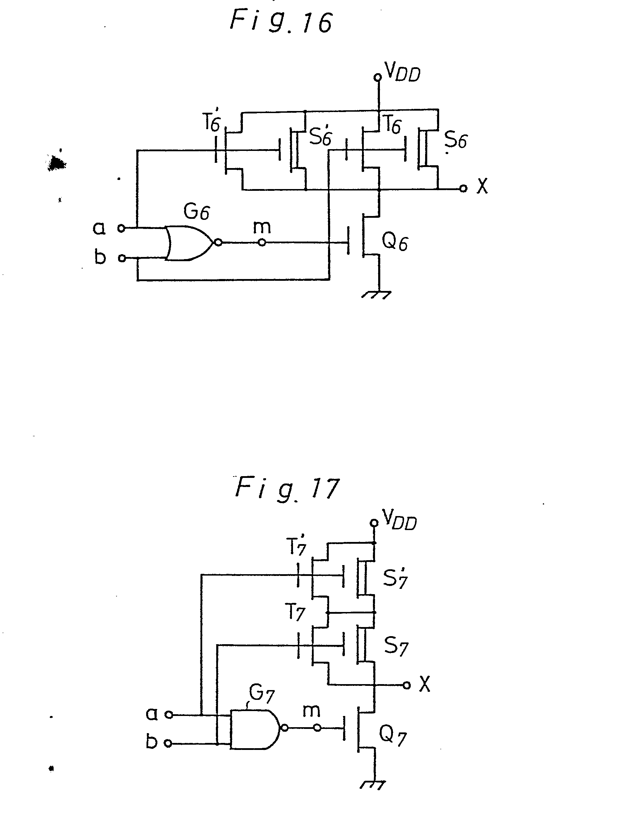

Figures 14 to 17 illustrate seventh to tenth embodiments of the present invention. The embodiments of Figures 14 and 15 illustrate cases in which the present invention is applied to the previously proposed logic circuits shown in Figures 5 and 6, respectively. The embodiments in Figures 16 and 17 are such that the use of depletion and enhancement-mode transistors is further applied to the first and second embodiments shown in Figures 7 and 8, respectively. In the seventh to tenth embodiments, depletion-mode MOS transistors are connected in parallel with load transistors or enhancement-mode MOS transistors. For example, the drain, source and gate of a

transistor $S_3$ are respectively connected to those of a load transistor $T_3$; the drain source and gate of a transistor $S_2$ are respectively connected to those of a load transistor $T_2$; and the drain, source and gate of a transistor $S_5$ are respectively connected to those of a load transistor $T_5$. As stated above, the operations of the depletion-mode MOS transistors provide for logic circuits whose outputs X are not affected by the threshold values of input gates and which are capable of multi-stage connection.

As described above, the present invention relates to a logic circuit of high operating speed and low power consumption, and a logic circuit of high operating speed and low power consumption can be provided by applying this invention. Further, the logic circuit can be manufactured by a simple process and at low cost.

Although embodiments of this invention have been described as employing the MOS type FET's, they are applicable to various other transistor logic circuits.

For example, an embodiment of the present invention provides a logic circuit comprising a multi-input NOR gate, a plurality of load FET's and a driving FET, the load FET's and driving FET being connected in series with each other between power sources of the circuit and the logical output being derived from the connection point of a load FET and the driving FET. The inputs of the NOR gate are equal in number to the load FET's. The inputs of the NOR gate are connected to the gates of corresponding load FET's and the output of the NOR gate is connected to the gate of the driving FET.

Claims

1. A logic circuit comprising:

first logic gate means, comprising at least one logic gate circuit having a plurality of logical input terminals, and

second logic gate means, comprising at least one logic gate circuit to which a logical output signal of the first logic gate means is applied,

the second logic gate means having at least one driving field-effect transistor (FET), and load FET's at least equal in number to the logical input terminals of the first logic gate means,

the said at least one driving FET being connected between a logical output terminal of the second logic gate means and one power-source terminal, and having its gate terminal connected to receive the logical output signal of the first logic gate means,

the load FET's being connected between the logical output terminal of the second logic gate means and another power-source terminal, and having their gate terminals connected with corresponding logical input terminals of the first logic gate means.

2. A logic circuit according to claim 1, wherein the first logic gate means is a multi-input NOR gate circuit, and the load FET's of the second logic gate means are connected in parallel with each other between the logical output terminal of the second logic gate means and the other power-source terminal.

3. A logic circuit as claimed in claim 2, wherein the inputs of the multi-input NOR gate are connected to the gates of corresponding load FET's.

4. A logic circuit as claimed in claim 2, wherein each input of the multi-input NOR gate is connected to the gates of the FET's of a respective pair of load FET's of the second logic gate means, each such pair of load FET's comprising an enhancement-mode FET and a depletion-mode FET whose sources, drains and gates are respectively connected in common.

5. A logic circuit as claimed in claim 1, wherein the first logic gate means is a multi-input NAND gate circuit, and load FET's of the second logic gate means are connected in series with one another between the logical output terminal of the second logic gate and the other power source terminal.

6. A logic circuit as claimed in claim 5, wherein the inputs of the multi-input NAND gate circuit are connected to the gates of corresponding load FET's.

7. A logic circuit as claimed in claim 5, wherein each input of the multi-input NAND gate circuit is connected to the
gates of the FET's of a respective pair of load FET's of
the second logic gate means, each such pair of load FET's
comprising an enhancement-mode FET and a depletion-mode
FET whose sources, drains and gates are respectively
connected in common.

8. A logic circuit as claimed in claim 1, wherein the first
logic gate means comprises a plurality of multi-input NOR
gate circuits, and the second logic gate means comprises
a plurality of groups of load FET's, the load FET's
within each group being connected in parallel, the respective
groups being provided in correspondence with respective
NOR gate circuits, and the respective groups being
connected in series with one another between the logical
output terminal of the second logic gate means and the other
power source terminal, and a plurality of driving FET's,
corresponding respectively to respective NOR gates,
connected in parallel between the logical output terminal of
the second logic gate means and the one power source
terminal.

9. A logic circuit as claimed in claim 1, wherein the first
logic gate means comprises a multi-input NOR gate circuit
and a multi-input NAND gate circuit, and the second logic
gate means comprises a parallel-connected group of load
FET's and a serial-connected group of load FET's, inputs of the NOR gate circuit being connected respectively to gates of corresponding FET's of the parallel-connected group, inputs of the NAND gate circuit being connected respectively to gates of corresponding FET's of the serial-connected group, the parallel-connected group being connected in series with the serial-connected group, and driving FET's, whose inputs are respectively connected to the outputs of the NAND gate circuit and the NOR gate circuit, connected in parallel with one another.

10. A logic circuit as claimed in claim 1, wherein the first logic gate means comprises a NOR gate circuit and a NAND gate circuit, and the second logic gate means comprises a parallel-connected group of load FET's and a serial-connected group of FET's, inputs of the NOR gate circuit being connected respectively to gates of corresponding FET's of the parallel-connected group, inputs of the NAND gate being connected respectively to gates of corresponding FET's of the serial-connected group, the serial-connected group being connected in parallel with the parallel-connected group, and driving FET's, whose inputs are respectively connected to the outputs of the NOR and NAND gate circuits, connected in series with one another.

11. A logic circuit as claimed in claim 1, wherein the first logic gate means comprises a plurality of NAND gate circuits, and the second logic gate means comprises a plurality of groups of load FET's, the load FET's within each group being connected in series, the respective groups being provided in correspondence with respective NAND gate circuits, and the respective groups being connected in parallel with one another, and a plurality of driving FET's, whose inputs are respectively connected to the outputs of said NAND circuits, connected in series with one another.

12. A logic circuit having a plurality of logic gate circuits, at least one of those logic gate circuits comprising driving field-effect transistor (FET) means and load FET means connected in series between voltage supply terminals of the logic circuit, a signal output end of another of the logic gate circuits being connected to an input terminal of the driving FET means of the one logic gate circuit, and a signal input end of that other logic gate circuit being connected to an input terminal of the load FET means, characterised in that the load FET means comprises an enhancement-mode FET and a depletion-mode FET whose sources, drains and gates are respectively connected in common.

13. A logic circuit as claimed in claim 12, wherein the said other logic gate circuit is an inverter.

14. A logic circuit as claimed in claim 12 or 13, wherein the said other logic gate circuit comprises a plurality of inverters, and the one logic gate circuit comprises a plurality of such load FET means, serially-connected, with their inputs respectively connected to inputs of the inverters, and the driving FET means comprises parallel-connected FET's whose inputs are respectively connected to outputs of the inverters.

15. A logic circuit as claimed in claim 12 or 13, wherein the said other logic gate circuit comprises a plurality of inverters, and the one logic gate circuit comprises a plurality of such load FET means, parallel-connected, with their inputs respectively connected to inputs of the inverters, and the driving FET means comprises serial-connected FET's whose inputs are respectively connected to outputs of the inverters.

*Fig.1A*   *Fig.1B*   *Fig.1C*

PRIOR ART   PRIOR ART   PRIOR ART

*Fig. 2A*   *Fig. 2B*   *Fig. 2C*

PRIOR ART   PRIOR ART   PRIOR ART

2/8

Fig. 3

PRIOR ART

Fig. 4

PRIOR ART

Fig. 5

Fig. 6

Fig. 7

Fig. 8

Fig. 9

0055570

4/8

5/8

Fig. 10

Fig. 11

Fig. 12

Fig. 13

0055570

## Fig. 14

## Fig. 15

8|8

Fig. 16

Fig. 17